# EUROPEAN PATENT APPLICATION

(11) **EP 4 489 066 A1**
(43) Date of publication of application: **08.01.2025**
(21) Application number: 23883975.7
(22) Date of filing: 09.01.2023
(51) Int. Cl.: H01L 21/768

(54) **SEMICONDUCTOR INTERCONNECTION STRUCTURE, FORMING METHOD THEREFOR, AND SEMICONDUCTOR PACKAGING STRUCTURE**

(30) Priority: 04.11.2022 CN 202211375324
(71) Applicant: CXMT Corporation, Hefei, Anhui 230601 (CN)
(72) Inventor: LIU, Chih-Cheng, Hefei, Anhui 230601 (CN)
(74) Representative: Gulde & Partner
(86) International application number: PCT/CN2023/071233
(87) International publication number: WO 2024/093025

(57) **Abstract**

An embodiment of the present disclosure provides a semiconductor interconnection structure, which includes a base, multiple independent conductive pillars, and a first conductive connection pad. The base has a first surface and a second surface that are disposed opposite to each other. The multiple independent conductive pillars are disposed in the base. One of the conductive pillars extends from the first surface to the second surface, a first end of the conductive pillar is exposed to the first surface, and a second end of the conductive pillar is exposed to the second surface. The first conductive connection pad is disposed on the first surface of the base and includes a mesh structure, and the mesh structure includes multiple first nodes. Each of the first nodes is connected to a first end of one or first ends of more of the conductive pillars, or a first end of each of the conductive pillars is connected to one or more of the first nodes. First ends of all the conductive pillars are interconnected through the first conductive connection pad. The semiconductor interconnection structure provided in the embodiment of the present disclosure has good heat dissipation performance and mechanical performance.

## Description

### CROSS-REFERENCE TO RELATED APPLICATIONS

This application claims priority to Chinese Patent Application No. 202211375324.4, filed on November 4, 2022, and entitled "SEMICONDUCTOR INTERCONNECTION STRUCTURE AND METHOD FOR FORMING SAME, AND SEMICONDUCTOR PACKAGE STRUCTURE", which is incorporated herein by reference in its entirety.

### TECHNICAL FIELD

The present disclosure relates to the field of integrated circuits, and in particular, to a semiconductor interconnection structure and a method for forming same, and a semiconductor package structure.

### BACKGROUND

The through silicon via (TSV) technology, a high-density packaging technology, is gradually replacing the currently mature wire bonding technology, and is considered the fourth-generation packaging technology. In the TSV technology, TSVs are filled with conductive materials such as copper, tungsten, and polysilicon, to implement vertical electrical interconnections of the TSVs. In the TSV technology, interconnection lengths, signal delays, and capacitance/inductance can be reduced through vertical interconnections, thereby implementing low-power and high-speed communication between chips, increasing bandwidth, and implementing miniaturization of device integration. Three-dimensional (3D) packaging based on the TSV technology offers superior electrical interconnection performance, wider bandwidth, higher interconnection density, lower power consumption, smaller size, and lighter weight.

As 3D packaging continues to develop, the TSV technology becomes increasingly important. The performance of TSVs directly impacts the reliability and yield of 3D packaging. To improve the reliability and yield of 3D packaging, it is essential to provide TSVs with high stability and reliability. Therefore, how to enhance the stability and reliability of TSVs has become an urgent issue that needs to be addressed at present.

### SUMMARY

A technical problem to be resolved in the present disclosure is to provide a semiconductor interconnection structure and a method for forming same, and a semiconductor package structure, which can improve heat dissipation performance and mechanical strength of the semiconductor interconnection structure.

To resolve the foregoing problem, the present disclosure provides a semiconductor interconnection structure, which includes: a base having a first surface and a second surface that are disposed opposite to each other; multiple independent conductive pillars disposed in the base, each of the conductive pillars extending from the first surface to the second surface, a first end of the conductive pillar being exposed to the first surface, and a second end of the conductive pillar being exposed to the second surface; and a first conductive connection pad disposed on the first surface of the base, the first conductive connection pad including a mesh structure, the mesh structure including multiple first nodes, each of the first nodes being connected to a first end of one or first ends of more of the conductive pillars, or a first end of each of the conductive pillars being connected to one or more of the first nodes, and first ends of all the conductive pillars being interconnected through the first conductive connection pad.

In an embodiment, the first conductive connection pad includes first patterns extending in a first direction and arranged at intervals in a second direction, and second patterns extending in the second direction and arranged in the first direction, and an intersection between the first pattern and the second pattern is the first node.

In an embodiment, the first node covers the first end of the conductive pillar.

In an embodiment, the semiconductor interconnection structure further includes a second conductive connection pad. The second conductive connection pad is disposed on the second surface of the base and connected to the second end of the conductive pillar, and second ends of all the conductive pillars are interconnected through the second conductive connection pad.

In an embodiment, the second conductive connection pad includes a mesh structure, the mesh structure includes multiple second nodes, and each of the second nodes is connected to a second end of one or second ends of more of the conductive pillars, or a second end of each of the conductive pillars is connected to one or more of the second nodes.

In an embodiment, the second conductive connection pad includes third patterns extending in a first direction and arranged at intervals in a second direction, and fourth patterns extending in the second direction and arranged in the first direction, and an intersection between the third pattern and the fourth pattern is the second node.

In an embodiment, the second node covers the second end of the conductive pillar.

In an embodiment, the base has a thickness of 30-50 micrometers.

In an embodiment, the conductive pillar has a maximum size range of 2-5 micrometers on a cross section parallel to the base.

In an embodiment, the conductive pillar is integrally formed with the first conductive connection pad.

In an embodiment, the first surface has a recess region, the recess region forms a trench, and the first conductive connection pad is at least partially located within the trench.

In an embodiment, the semiconductor interconnection structure further includes a seed layer, and the seed layer is disposed between the conductive pillar and the base and between the first conductive connection pad and the base.

An embodiment of the present disclosure further provides a method for forming a semiconductor interconnection structure. The method includes the steps as follows. A base is provided. Multiple through-holes and multiple trenches are formed in the base. The multiple trenches are connected to form a mesh trench, one or more of the through-holes are exposed by one node opening of the mesh trench exposes, or one of the through-holes is exposed by one or more node openings of the mesh trench. The through-holes and the mesh trench are filled with a conductive material to form conductive pillars in the through-hole and to form a first conductive connection pad in the mesh trench. The base is thinned and an end, away from the first conductive connection pad, of the conductive pillar is exposed.

In an embodiment, the step of forming the through-hole and the mesh trench in the base includes the steps as follows. Through-holes are formed in the base. The through-holes are arranged in an array in a first direction and a second direction. A partial thickness of the base is removed to form multiple first trenches and multiple second trenches. The first trenches extend in the first direction and are arranged at intervals in the second direction, the second trenches extend in the second direction and are arranged at intervals in the first direction, the first trench and the second trench run through the through-hole, and an intersection region between the first trench and the second trench is the node opening.

In an embodiment, the step of forming the through-holes and the mesh trench in the base includes the steps as follows. A partial thickness of the base is removed to form multiple first trenches and multiple second trenches. The first trenches extend in the second direction and are arranged at intervals in the first direction, the second trenches extend in the first direction and are arranged at intervals in the second direction, and an intersection region between the first trench and the second trench is the node opening. The base is removed in a direction perpendicular to the base at the node opening to form the through-holes.

In an embodiment, before the step of filling the through-holes and the mesh trench with the conductive material, the method further includes the steps as follows. A seed layer is formed on inner walls of the through-holes and the mesh trench. The seed layer is covered by the conductive material, and the through-holes and the mesh trench are fully filled with the conductive material in the step of filling the through-hole and the mesh trench with the conductive material.

An embodiment of the present disclosure further provides a semiconductor package structure, including the semiconductor interconnection structure described above.

According to the semiconductor interconnection structure and the method for forming same, and the semiconductor package structure that are provided in the embodiments of the present disclosure, a conductive pillar with a large cross-sectional area is separated, by the semiconductor interconnection structure, into a conductive pillar array formed by multiple conductive pillars with a small cross-sectional area, greatly increasing a surface area of the conductive pillar and improving heat dissipation performance of the semiconductor interconnection structure. In addition, the multiple conductive pillars are dispersedly disposed in the base, and the base further supports the conductive pillars, thereby improving mechanical performance of the semiconductor interconnection structure. In addition, the first conductive connection pad is a mesh structure rather than a one-piece structure, increasing a surface area of the first conductive connection pad, and further increasing a heat dissipation area of the semiconductor interconnection structure.

### BRIEF DESCRIPTION OF DRAWINGS

FIG. 1A is a top view of a semiconductor interconnection structure according to a first embodiment of the present disclosure;
FIG. 1B is a schematic diagram of a cross section along a line A-A' in FIG. 1A;
FIG. 2 is a three-dimensional schematic diagram of a semiconductor interconnection structure according to a second embodiment of the present disclosure;
FIG. 3A is a top view of a semiconductor interconnection structure according to a second embodiment of the present disclosure;
FIG. 3B is a schematic diagram of a cross section along a line B-B' in FIG. 3A;
FIG. 4 is a top view of a semiconductor interconnection structure according to a third embodiment of the present disclosure;
FIG. 5A is a top view of a semiconductor interconnection structure according to a fourth embodiment of the present disclosure;
FIG. 5B is a top view of a semiconductor interconnection structure according to a fifth embodiment of the present disclosure;
FIG. 6 is a bottom view of a semiconductor interconnection structure according to a sixth embodiment of the present disclosure;
FIG. 7 is a schematic diagram of steps of a method for forming a semiconductor interconnection structure according to a seventh embodiment of the present disclosure;
FIG. 8A-FIG. 8M are schematic diagrams of a semiconductor structure formed based on main steps of the method according to the seventh embodiment of the present disclosure;
FIG. 9A~FIG. 9B are schematic diagrams of a semiconductor structure formed based on main steps of the method according to the eighth embodiment of the present disclosure; and
FIG. 10 is a schematic diagram of a semiconductor package structure according to a ninth embodiment of the present disclosure.

### DESCRIPTION OF EMBODIMENTS

Specific implementations of the semiconductor interconnection structure and the method for forming same, and the semiconductor package structure that are provided in the present disclosure are described below in detail with reference to accompanying drawings. The semiconductor package structure in the specific implementations may be but is not limited to a dynamic random access memory (DRAM).

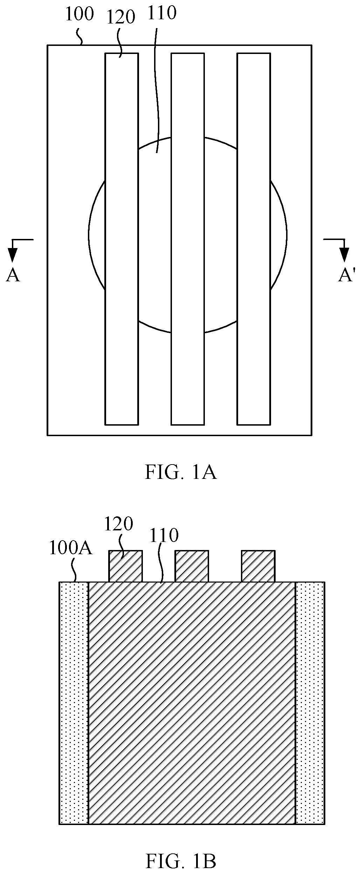

FIG. 1A is a top view of a semiconductor interconnection structure according to a first embodiment of the present disclosure. FIG. 1B is a schematic diagram of a cross section along a line A-A' in FIG. 1A. Reference is made to FIG. 1A and FIG. 1B. The semiconductor interconnection structure includes a base 100, a conductive pillar 110, and a first conductive connection pad 120. The conductive pillar 110 penetrates the base 100, and is connected to the first conductive connection pad 120 disposed on a first surface 100A of the base 100. The conductive pillar 110 includes but is not limited to a through silicon via structure, and is electrically connected to another semiconductor structure through the first conductive connection pad 120. In the first embodiment, one conductive pillar may be connected to multiple first conductive connection pads 120. For example, three first conductive connection pads 120 disposed independently are depicted in FIG. 1A and FIG. 1B. The three first conductive connection pads 120 disposed independently are connected to the same conductive pillar 110.

The inventors found that heat dissipation performance and mechanical performance of the semiconductor interconnection structure provided in the first embodiment are poor and cannot meet a requirement. After further researches, the inventors provide a semiconductor interconnection structure, which can improve the heat dissipation performance and mechanical performance of the semiconductor interconnection structure.

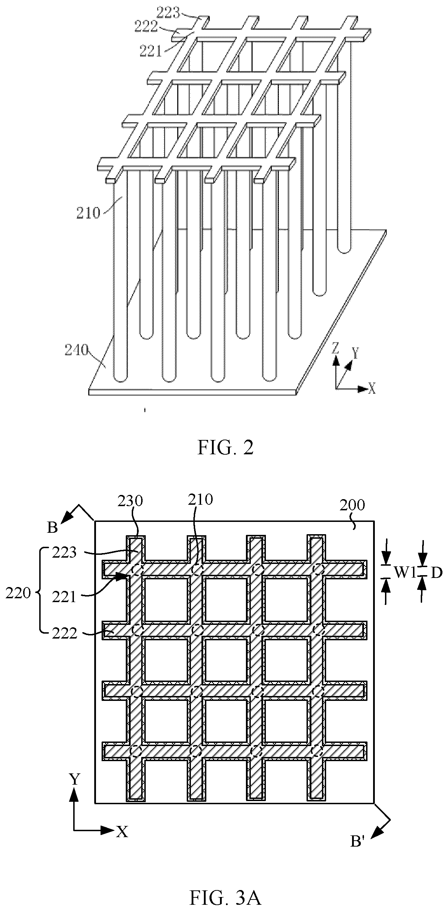

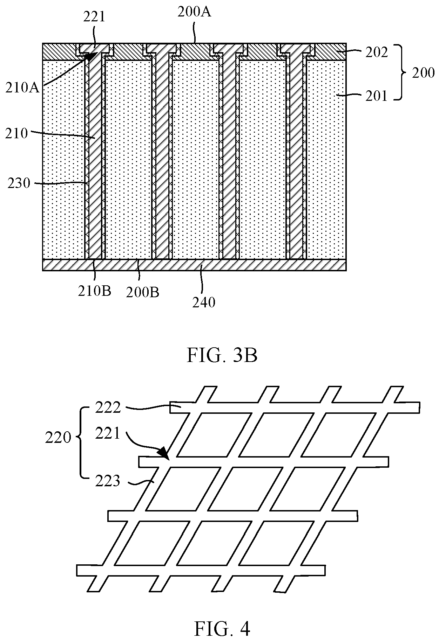

FIG. 2 is a three-dimensional schematic diagram of a semiconductor interconnection structure according to a second embodiment of the present disclosure. FIG. 3A is a top view of a semiconductor interconnection structure according to a second embodiment of the present disclosure. FIG. 3B is a schematic diagram of a cross section along a line B-B' in FIG. 3A. To clearly display the semiconductor interconnection structure provided in the embodiments of the present disclosure, a base 200 is not depicted FIG. 2. Reference is made to FIG. 2, FIG. 3A, and FIG. 3B. The semiconductor interconnection structure includes a base 200, multiple independent conductive pillars 210, and a first conductive connection pad 220. The base 200 has a first surface 200Aand a second surface 200B that are disposed opposite to each other. The multiple independent conductive pillars 210 are disposed in the base 200. Each of the conductive pillars 210 extends from the first surface 200A to the second surface 200B, a first end 210A of the conductive pillar 210 is exposed to the first surface 200A, and a second end 210B of the conductive pillar 210 is exposed to the second surface 200B. The first conductive connection pad 220 is disposed on the first surface 200A of the base 200 and includes a mesh structure, and the mesh structure includes multiple first nodes 221. Each of the first nodes 221 is connected to a first end 210A of one or first ends 210A of more of the conductive pillars 210, or a first end 210A of each of the conductive pillars 210 is connected to one or more of the first nodes 221. First ends 210A of all the conductive pillars 210 are interconnected through the first conductive connection pad 220. In the top view (e.g., FIG. 2), the conductive pillar 210 is blocked by the first conductive connection pad 220. To clearly describe the technical solutions in the embodiments of the present disclosure, a contour of the conductive pillar 210 is depicted by dotted lines.

A conductive pillar 210 with a large cross-sectional area is separated, by the semiconductor interconnection structure provided in this embodiment, into a conductive pillar array formed by multiple conductive pillars 210 with a small cross-sectional area, greatly increasing a surface area of the conductive pillar 210 and improving heat dissipation performance of the semiconductor interconnection structure. In addition, the multiple conductive pillars 210 are dispersedly disposed in the base 200, and the base 200 further supports the conductive pillars 210, thereby improving mechanical performance and deformation resistance of the semiconductor interconnection structure. In addition, the first conductive connection pad 220 is a mesh structure rather than a one-piece structure, increasing a surface area of the first conductive connection pad 220, and further increasing a heat dissipation area of the semiconductor interconnection structure. Furthermore, the mesh structure of the first conductive connection pad 220 can further improve deformation resistance of the conductive pillar array, thereby improving support performance of the semiconductor interconnection structure.

In this embodiment, the base 200 includes a substrate 201 and a protective layer 202 disposed on a surface of the substrate 201. The protective layer 202 may be an oxide layer or a nitride layer. In some other embodiments, the base 200 may alternatively include only the substrate 201.

The substrate 201 may include a silicon substrate, a germanium (Ge) substrate, a silicon germanium (SiGe) substrate, a silicon-on-insulator (SOI) substrate, and the like. The substrate 201 may alternatively be a substrate including another element semiconductor or compound semiconductor, such as gallium arsenide, indium phosphide, or silicon carbide. The substrate 201 may alternatively be a stacked structure, such as a silicon/silicon germanium stack. In addition, the substrate 201 may be an ion-doped substrate on which P-type doping or N-type doping may be performed. Multiple peripheral devices may also be formed in the substrate 201, such as a field effect transistor, a capacitor, an inductor, and/or a diode. In this embodiment, the substrate 201 is a silicon substrate, and another device structure, such as a transistor structure or a metal wiring structure may also be included in the substrate 201, but is not depicted as it is irrelevant to the present invention.

In this embodiment, the first surface 200A of the base 200 is an upper surface of the base 200, the second surface 200B of the base 200 is a lower surface of the base 200, and the upper surface and the lower surface are disposed opposite to each other.

The multiple conductive pillars 210 are disposed independently of each other, that is, the multiple conductive pillars 210 are not in contact with each other. In this embodiment, each conductive pillar 210 extends in a direction (e.g., a Z direction in FIG. 2) perpendicular to the first surface 200A of the base 200, and the multiple conductive pillars 210 are arranged at intervals in a direction (e.g., an X direction in FIG. 2) parallel to the first surface 200A of the base 200, and are parallel to each other.

Each conductive pillar 210 penetrates the base 200 in the direction (e.g., the Z direction in FIG. 2) perpendicular to the first surface 200A of the base 200, the first end 210A of the conductive pillar 210 is exposed to the first surface 200A, and the second end 210B of the conductive pillar 210 is exposed to the second surface 200B. In this embodiment, the first surface 200A of the base 200 has a groove configured to insert the first conductive connection pad 220, so that the first end 210A of the conductive pillar 210 is exposed to the bottom surface of the groove.

If the conductive pillar 210 is formed in the base 200, a through-hole needs to be formed first, and then the conductive pillar 210 is formed in the through-hole. However, an aspect ratio of the through-hole is affected by requirements on the thickness of the base 200 and the width of the conductive pillar 210. A larger thickness of the base 200 and a smaller width of the conductive pillar 210 lead to a larger aspect ratio of the through-hole. For through-holes with a high aspect ratio, an etching material cannot completely enter the bottoms of the through-holes, and the bottoms of the through-holes are not completely etched. In this case, the formed through-holes are wide on tops and narrow at bottoms, and consequently the conductive pillars 210 formed in the through-holes also have inconsistent widths. In addition, the conductive material forming the conductive pillar 210 is insufficiently deposited at the bottom of the through-hole, and consequently the conductive pillar 210 formed at the bottom of the through-hole is deficient, affecting reliability of the conductive pillar 210. Therefore, in some embodiments, the thickness (a size in the Z direction in FIG. 2) of the base 200 is small, for example, in the second embodiment, the thickness of the base 200 is 30-50 micrometers, so that a conductive pillar 210 with a small width (a size in the X direction in FIG. 2) can be formed. For example, in the second embodiment, the conductive pillar 210 has a maximum size range of 2-5 micrometers on a cross section parallel to the base 200, avoiding a problem caused by a through-hole with a high aspect ratio, and further ensuring the width consistency (the size in the Z direction in FIG. 2) in the extension direction and the reliability of the conductive pillar 210.

In some embodiments, the first conductive connection pad 220 is disposed on the first surface 200A of the base 200, that is, the first conductive connection pad 220 protrudes from the base 200. In some other embodiments, the first surface 200A of the base 200 has a mesh recess region forming a trench. The first conductive connection pad 220 is at least partially located in the trench, that is, the first conductive connection pad 220 extends beneath the first surface 200A. For example, in the second embodiment, the first conductive connection pad 220 is completely located in the trench, and the top surface of the first conductive connection pad 220 is flush with the first surface 200A of the base 200. Because the first conductive connection pad 220 is embedded into the base 200, a protrusion between the trenches of the base 200 can fit into a gap in the mesh structure of the first conductive connection pad 220, thereby enhancing mechanical strength of the first conductive connection pad 220, and further improving mechanical strength of the semiconductor interconnection structure.

In the embodiments of the present disclosure, the first ends 210A of all the conductive pillars 210 are interconnected through the first conductive connection pad 220, and an electrical signal of the first conductive connection pad 220 is transmitted through all the conductive pillars 210 instead of only one or some of the conductive pillars 210. In other words, all the conductive pillars 210 function as a same conductive structure instead of multiple conductive structures.

In some embodiments, the first conductive connection pad 220 includes first patterns 222 extending in a first direction and arranged at intervals in a second direction, and second patterns 223 extending in the second direction and arranged in the first direction, and an intersection between the first pattern 222 and the second pattern 223 is the first node 221. In this embodiment, the first direction is perpendicular to the second direction, for example, the first direction is an X direction and the second direction is a Y direction. The first pattern 222 is a strip-shaped pattern extending in the X direction, and multiple strip-shaped patterns are arranged at intervals in the Y direction. The second pattern 223 is a strip-shaped pattern extending in the Y direction, and multiple strip-shaped patterns are arranged at intervals in the X direction.

In this embodiment, the first pattern 222 is disposed perpendicular to the second pattern 223. In some other embodiments, as shown in FIG. 4, a top view of a semiconductor interconnection structure according to a third embodiment of the present disclosure, the first pattern 222 and the second pattern 223 are disposed at an acute angle, not at a 90-degree angle.

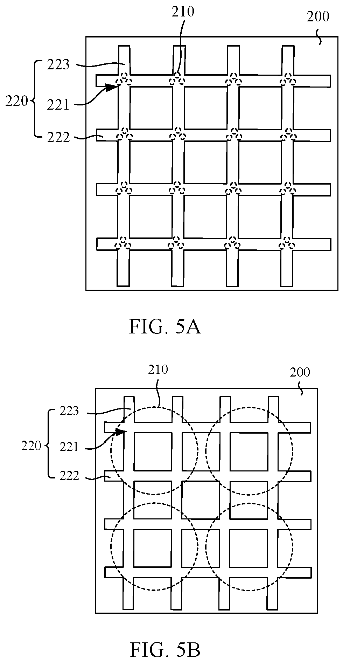

In this embodiment, one first node 221 is connected to a first end 210A of one conductive pillar 210, that is, the first node 221 and the conductive pillar 210 are in a one-to-one correspondence. In some other embodiments, the first node 221 and the conductive pillar 210 are in a one-to-many or many-to-one correspondence. For example, as shown in FIG. 5A, a top view of a semiconductor interconnection structure according to a fourth embodiment of the present disclosure, each first node 221 is connected to first ends 210A of multiple conductive pillars 210, that is, multiple conductive pillars 210 are disposed below each first node 221. For another example, as shown in FIG. 5B, a top view of a semiconductor interconnection structure according to a fifth embodiment of the present disclosure, a first end 210A of one conductive pillar 210 is connected to multiple first nodes 221, that is, multiple first nodes 221 are disposed above each conductive pillar 210.

In some embodiments, the first node 221 covers the first end 210A of the conductive pillar 210, that is, a projection of the conductive pillar 210 on the substrate 201 is located within a projection of the first node 221 on the substrate 201. Specifically, in this embodiment, the first node 221 is connected to the conductive pillar 210 in a one-to-one correspondence. The first node 221 covers the first end 210A of the conductive pillar 210, that is, the length W1 of the shortest edge of the first node 221 is greater than the diameter D of the conductive pillar 210, so that the conductive pillar 210 can be applied to the greatest extent, and conductive performance of the semiconductor interconnection structure is improved.

In some embodiments, the conductive pillar 210 is integrally formed with the first conductive connection pad 220, that is, the conductive pillar 210 and the first conductive connection pad 220 are fabricated with the same conductive material in one step of the same step process, greatly reducing a contact resistance between the conductive pillar 210 and the first conductive connection pad 220, and improving conductive performance of the semiconductor interconnection structure.

In some embodiments, the semiconductor interconnection structure further includes a seed layer 230. The seed layer 230 is disposed between the conductive pillar 210 and the base 200 and between the first conductive connection pad 220 and the base 200. The seed layer 230 insulates the conductive pillar 210 from the base 200, and the first conductive connection pad 220 from the base 200. The seed layer 230 may be an oxide layer, such as a silicon oxide layer.

Another semiconductor structure (e.g., a semiconductor device) may be electrically connected to the second end 210B of the conductive pillar 210 on the second surface 200B of the base 200, thereby implementing electrical connection between the semiconductor structure and the first conductive connection pad 220.

To further improve reliability of connecting the semiconductor structure to the second end of the conductive pillar 210, a second conductive connection pad 240 is disposed on the second surface 200B of the base 200, and the semiconductor structure is connected to the second conductive connection pad 240, and is connected to the first conductive connection pad 220 through the second conductive connection pad 240 and the conductive pillar 210. The second conductive connection pad 240 covers the second surface 200B of the base 200 and is connected to the second end 210B of the conductive pillar 210. The second ends 210B of all the conductive pillars 210 are interconnected through the second conductive connection pad 240.

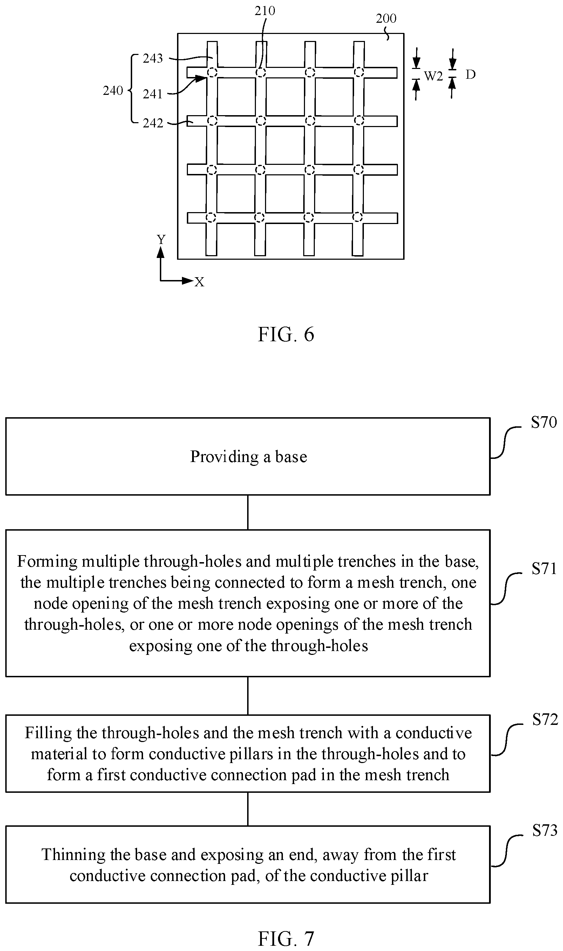

In the second embodiment, the second conductive connection pad 240 is a one-piece structure. In the sixth embodiment of the present disclosure, the second conductive connection pad 240 includes a mesh structure. FIG. 6 is a bottom view of a semiconductor interconnection structure according to the sixth embodiment of the present disclosure. The conductive pillar 210 is blocked by the second conductive connection pad 240. To clearly describe the technical solutions in the embodiments of the present disclosure, a contour of the conductive pillar 210 is depicted by dotted lines. The second conductive connection pad 240 includes a mesh structure, the mesh structure includes multiple second nodes 241, and each of the second nodes 241 is connected to a second end 210B of one or second ends 210B of more of the conductive pillars 210, or a second end 210B of each of the conductive pillars 210 is connected to one or more of the second nodes 241. The second conductive connection pad 240 is a mesh structure rather than a one-piece structure, increasing a surface area of the second conductive connection pad 240, and further increasing a heat dissipation area of the semiconductor interconnection structure. Furthermore, the mesh structure of the second conductive connection pad 240 can further improve deformation resistance of the conductive pillar array, thereby improving support performance of the semiconductor interconnection structure.

In some embodiments, the second conductive connection pad 240 is disposed on the second surface 200B of the base 200, that is, the second conductive connection pad 240 protrudes from the base 200. In some other embodiments, for example, in the sixth embodiment, the second surface 200B of the base 200 has a recess region forming a trench. The second conductive connection pad 240 is at least partially located in the trench, that is, the second conductive connection pad 240 extends beneath the second surface 200B. For example, in the second embodiment, the second conductive connection pad 240 is completely located in the trench, and the top surface of the second conductive connection pad 240 is flush with the second surface 200B of the base 200. Because the second conductive connection pad 240 is embedded into the base 200, a protrusion between the trenches of the base 200 can fit into a gap in the mesh structure of the second conductive connection pad 240, thereby enhancing mechanical strength of the second conductive connection pad 240, and further improving mechanical strength of the semiconductor interconnection structure.

In this embodiment, one second node 241 is connected to a second end 210B of one conductive pillar 210, that is, the second node 241 and the conductive pillar 210 are in a one-to-one correspondence. In some other embodiments, the second node 241 and the conductive pillar 210 are in a one-to-many or many-to-one correspondence. Reference is made to FIG. 5A and FIG. 5B, and details are not described herein again.

The second conductive connection pad 240 includes third patterns 242 extending in a first direction (e.g., an X direction in FIG. 6) and arranged at intervals in a second direction (e.g., a Y direction in FIG. 6), and fourth patterns 243 extending in the second direction (e.g., the Y direction in FIG. 6) and arranged in the first direction (e.g., the X direction in FIG. 6), and an intersection between the third pattern 242 and the fourth pattern 243 is the second node 241. In this embodiment, the third pattern 242 is disposed perpendicular to the fourth pattern 243. In some other embodiments, the third pattern 242 and the fourth pattern 243 are disposed at an acute angle, not at a 90-degree angle. Reference is made to FIG. 4.

In this embodiment, the structure of the second conductive connection pad 240 is the same as the structure of the first conductive connection pad 220. It may be understood that in some other embodiments, the structure of the second conductive connection pad 240 is different from the structure of the first conductive connection pad 220. Details are not described again.

In some embodiments, the second node 241 covers the second end 210B of the conductive pillar 210, that is, a projection of the conductive pillar 210 on the substrate 201 is located within a projection of the second node 241 on the substrate 201. Specifically, in this embodiment, the second node 241 is connected to the conductive pillar 210 in a one-to-one correspondence. The second node 241 covers the second end 210B of the conductive pillar 210, that is, the length W2 of the shortest edge of the second node 241 is greater than the diameter D of the conductive pillar 210, so that the conductive pillar 210 can be applied to the greatest extent, and conductive performance of the semiconductor interconnection structure is improved.

An embodiment of the present disclosure further provides a method for forming a semiconductor interconnection structure. FIG. 7 is a schematic diagram of steps of a method for forming a semiconductor interconnection structure. The method includes the steps as follows. In the step of S70, a base is provided. In the step of S71, multiple through-holes and multiple trenches are formed in the base. The multiple trenches are connected to form a mesh trench, one or more of the through-holes are exposed by one node opening of the mesh trench, or one of the through-holes is exposed by one or more node openings of the mesh trench. In the step of S72, the through-holes and the mesh trench are filled with a conductive material to form conductive pillars in the through-holes and to form a first conductive connection pad in the mesh trench. In the step of S73, the base is thinned and an end, away from the first conductive connection pad, of the conductive pillar is exposed.

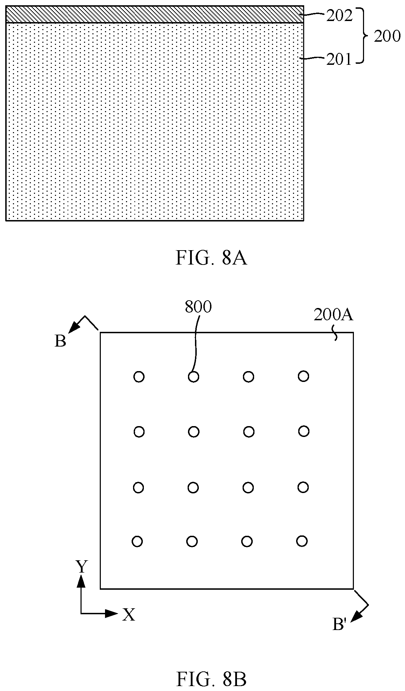

FIG. 8A-FIG. 8M are schematic diagrams of a semiconductor structure formed based on main steps of the method according to the seventh embodiment of the present disclosure.

Reference is made to FIG. 7 and FIG. 8A. In the step of S70, the base 200 is provided. In this embodiment, the base 200 includes a substrate 201 and a protective layer 202 disposed on a surface of the substrate 201. In some other embodiments, the base 200 may alternatively include only the substrate 201.

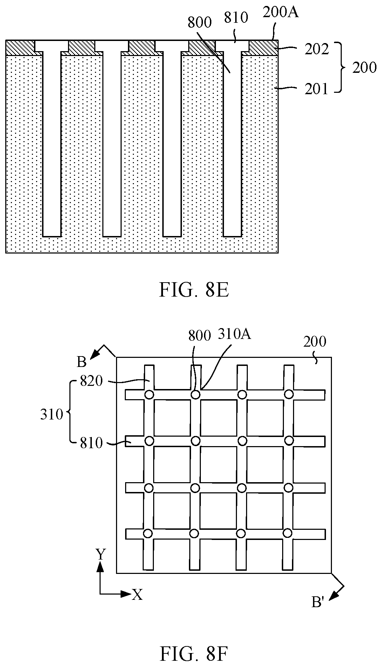

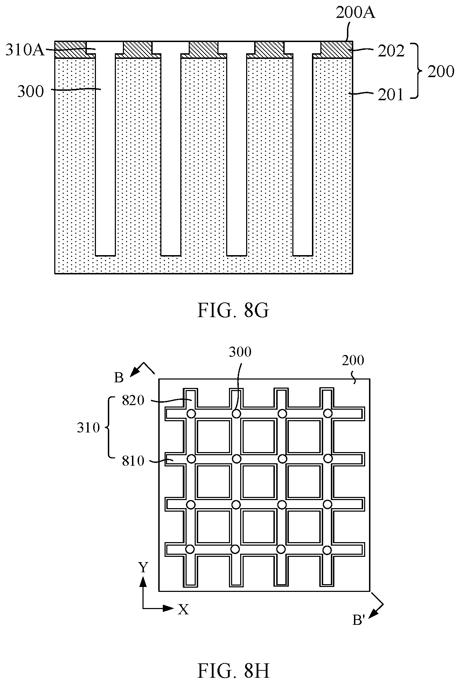

Reference is made to FIG. 7, FIG. 8F, and FIG. 8G. In the step of S71, the multiple through-holes 300 and the multiple trenches 310 are formed in the base 200. The multiple trenches are connected to form the mesh trench 310, one or more of the through-holes 300 are exposed by one node opening 310A of the mesh trench 310, or one of the through-holes 300 is exposed by one or more node openings 310A of the mesh trench 310. In this step, the through-hole 300 extends from the first surface 200A of the base 200 to the inside of the base 200, but does not penetrate the base 200, that is, the through-hole 300 is a blind hole.

In an example, the seventh embodiment of the present disclosure provides a method for forming the through-hole 300 in the base 200. The method includes the steps as follows.

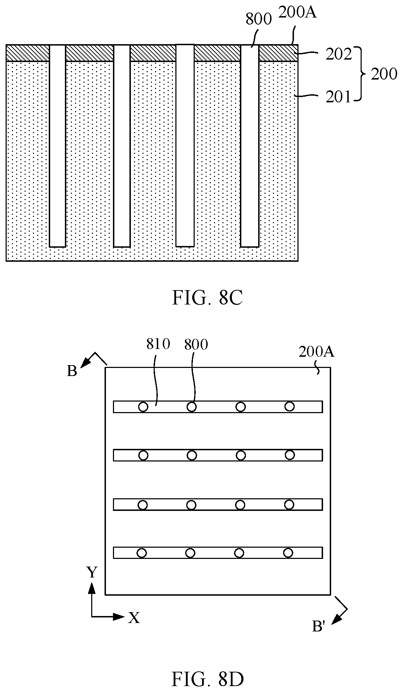

Reference is made to FIG. 8B and FIG. 8C. FIG. 8B is a top view, and FIG. 8C is a schematic diagram of a cross section along a line B-B' in FIG. 8B. Through-holes 800 are formed in the base 200, and the through-holes 800 are arranged in an array in a first direction and a second direction. In this embodiment, the first direction is the X direction, and the second direction is the Y direction. In this step, a mask layer having a pattern corresponding to the through-hole 800 may function as a shield, and the base 200 is etched. The pattern of the mask layer is transferred to the base 200 to form the through-hole 800, and the mask layer is removed. The depth of the through-hole 800 may be set according to a height requirement of the conductive pillar 210 that needs to be formed subsequently. In this embodiment, because the first trench 810 and the second trench 820 need to be formed at an end of the through-hole subsequently, the depth of the through-hole 800 is greater than the depth of the conductive pillar 210 that needs to be formed subsequently, for example, the depth of the through-hole 800 is equal to the sum of the height of the subsequently formed conductive pillar 210 and the depth of the first trench 810.

After the through-hole 800 is formed, a partial thickness of the base 200 is removed to form multiple first trenches 810 and multiple second trenches 820. The first trenches 810 extend in the first direction and are arranged at intervals in the second direction, the second trenches 820 extend in the second direction and are arranged at intervals in the first direction, the first trench 810 and the second trench 820 run through the through-hole 800, and an intersection region between the first trench 810 and the second trench 820 is the node opening 310A.

Specifically, reference is made to FIG. 8D and FIG. 8E. FIG. 8D is a top view, and FIG. 8E is a schematic diagram of a cross section along a line B-B' in FIG. 8D. A partial thickness of the base 200 is removed to form multiple first trenches 810. The first trench 810 extends in the first direction and runs through the through-hole 800. In this step, a mask layer having a pattern corresponding to the first trench 810 functions as a shield, and the base 200 is etched. The pattern of the mask layer is transferred to the base 200 to form the first trench 810, and the mask layer is removed. In this embodiment, the first direction is perpendicular to the second direction, for example, the first direction is the X direction, and the second direction is the Y direction.

Reference is made to FIG. 8F and FIG. 8G. FIG. 8F is a top view, and FIG. 8G is a schematic diagram of a cross section along a line B-B' in FIG. 8F. A partial thickness of the base 200 is removed to form multiple second trenches 820. The second trench 820 extends in the second direction and runs through the through-hole 800. The first trench 810 and the second trench 820 cross each other to form a mesh trench 310. An intersection region between the first trench 810 and the second trench 820 is the node opening 310A. In this step, a mask layer having a pattern corresponding to the second trench 820 functions as a shield, and the base 200 is etched. The pattern of the mask layer is transferred to the base 200 to form the second trench 820, and the mask layer is removed.

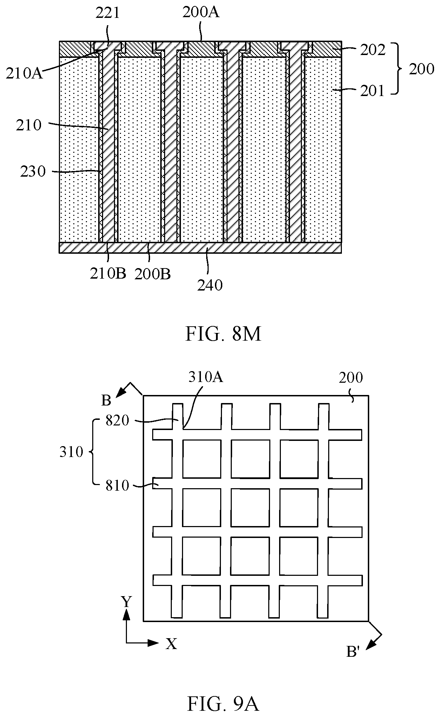

In an example, the eighth embodiment of the present disclosure further provides a method for forming the through-hole 300 in the base 200. Reference is made to FIG. 9A-FIG. 9B. The method for forming a through-hole 300 in a base 200 includes the steps as follows.

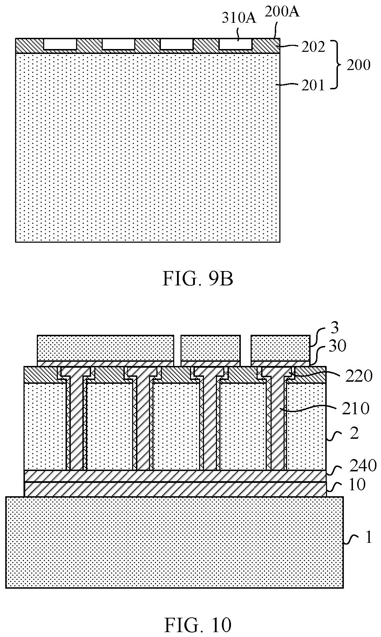

Reference is made to FIG. 9A and FIG. 9B. FIG. 9A is a top view, and FIG. 9B is a schematic diagram of a cross section along a line B-B' in FIG. 9A. A partial thickness of the base 200 is removed to form multiple first trenches 810 and multiple second trenches 820. The first trenches 810 extend in a first direction (e.g., an X direction in FIG. 9A) and are arranged at intervals in a second direction (e.g., a Y direction in FIG. 9A). The second trenches 820 extend in the second direction (e.g., the Y direction in FIG. 9A) and are arranged at intervals in the first direction (e.g., the X direction in FIG. 9A). The first trenches 810 intersect with the second trenches 820 to form the mesh structure. An intersection region between the first trench 810 and the second trench 820 is the node opening 310A.

In this step, a mask layer having a pattern corresponding to the first trench 810 may function as a shield, and the base 200 is etched. The pattern of the mask layer is transferred to the base 200 to form the first trench 810. A mask layer having a pattern corresponding to the second trench 820 may function as a shield, and the base 200 having the first trench 810 is etched. The pattern of the mask layer is transferred to the base 200 to form the second trench 820. The mask layer is removed after the second trench 820 is formed.

After the first trench 810 and the second trench 820 are formed, the base 200 is removed at the node opening 310A in the direction perpendicular to the base 200 to form the through-hole 300. For example, in this embodiment, a mask layer having a pattern corresponding to the through-hole may cover a surface of the base 200, and the mask layer functions as a shield to etch the base 200 to form the through-hole 300.

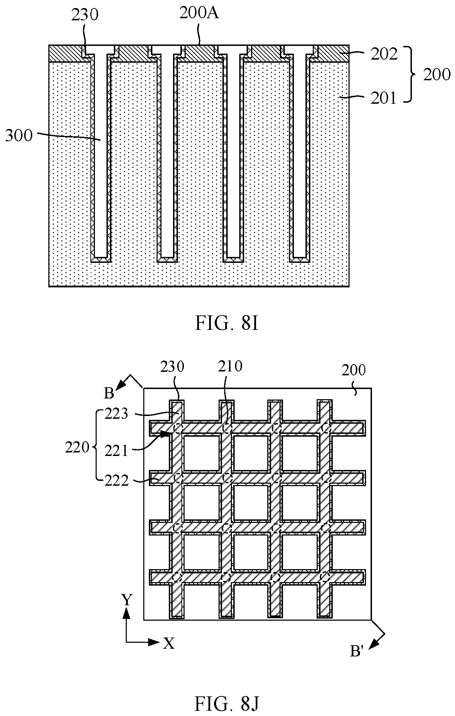

Reference is made to FIG. 8H and FIG. 8I. FIG. 8H is a top view, and FIG. 8I is a schematic diagram of a cross section along a line B-B' in FIG. 8H. After the through-hole 300 and the mesh trench 310 are formed, a seed layer 230 is formed on an inner wall of the through-hole 300. The seed layer 230 covers the inner walls of the through-hole 300 and the mesh trench, and the seed layer 230 may be configured to insulate the base 200 from the conductive pillar 210 and the first conductive connection pad 220. The seed layer 230 includes but is not limited to an oxide layer, and may be formed through a chemical vapor deposition process, a thermal oxidation process, or the like.

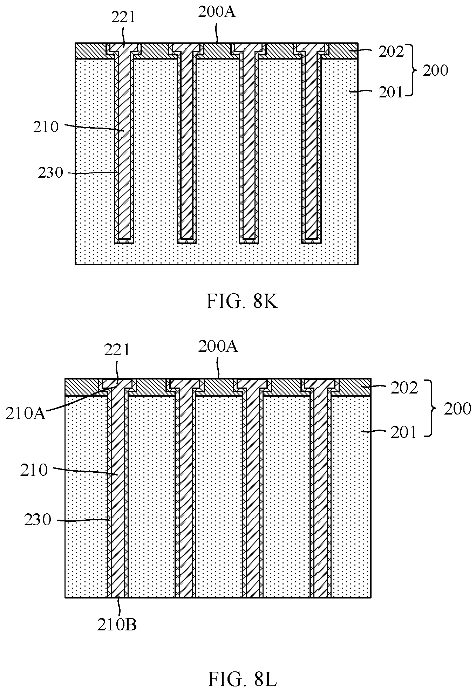

Reference is made to FIG. 7, FIG. 8J, and FIG. 8K. FIG. 8J is a top view, and FIG. 8K is a schematic diagram of a cross section along a line B-B' in FIG. 8J. In the step of S72, the through-holes 300 and the mesh trench 310 are filled with the conductive material to form the conductive pillars 210 in the through-holes 300 and to form a first conductive connection pad 220 in the mesh trench 310. In this step, a conductive material may be deposited through a process such as chemical vapor deposition or atomic layer deposition, and the through-holes 300 and the mesh trench 310 are fully filled with the conductive material. In this embodiment, the surface of the seed layer 230 is covered by the conductive material, and the through-holes 300 and the mesh trench 310 are fully filled with the conductive material. In some embodiments, the first surface 200A of the base 200 is further covered by the conductive material, and the conductive material is removed through a chemical mechanical polishing process until the first surface 200A of the base 200 to form the first conductive connection pad 220 having a flat surface. The conductive material includes but is not limited to copper.

Because the first conductive connection pad 220 and the conductive pillar 210 are formed with the same conductive material in the same step, there is no substantial junction interface between the first conductive connection pad 220 and the conductive pillar 210, a contact resistance is small, and connectivity is better, greatly improving electrical performance and mechanical performance of the semiconductor interconnection structure.

Reference is made to FIG. 7 and FIG. 8L. FIG. 8L is a schematic diagram of a cross section. In the step of S73, the base 200 is thinned, and an end, away from the first conductive connection pad 220, of the conductive pillar 210 is exposed. In this step, the base 200 may be thinned through a process such as chemical mechanical polishing until the second end 210B of the conductive pillar 210 is exposed, facilitating subsequent electrical connection between another semiconductor structure and the conductive pillar 210. After this step, the second end 210B of the conductive pillar 210 is exposed to the second surface 200B of the base 200.

FIG. 8M is a schematic diagram of a cross section. In some embodiments, after the base 200 is thinned, the method further includes the step of forming the second conductive connection pad 240 on the second surface 200B of the base 200. In some embodiments, a conductive layer may be directly formed on the second surface 200B of the base 200, and the conductive layer is patterned to form the second conductive connection pad 240.

In the method for forming a semiconductor interconnection structure provided in the embodiments of the present disclosure, the conductive pillar 210 and the first conductive connection pad 220 may be formed through only a one-step etching process in the same step. Therefore, compared with forming the conductive pillar 210 and the first conductive connection pad 220 through a two-step etching process in different steps, the process is simpler, and destruction of a connection interface between the conductive pillar 210 and the first conductive connection pad 220 by the etching process is avoided, thereby improving electrical performance, mechanical performance, and stability of the semiconductor interconnection structure.

An embodiment of the present disclosure further provides a semiconductor package structure, including the foregoing semiconductor interconnection structure. FIG. 10 is a schematic diagram of a semiconductor package structure according to a ninth embodiment of the present disclosure. The semiconductor package structure includes a first semiconductor structure 1, a semiconductor interconnection structure 2, and a second semiconductor structure 3. The first semiconductor structure 1 is electrically connected to the second semiconductor structure 3 through the semiconductor interconnection structure 2. Specifically, a third conductive connection pad 10 of the first semiconductor structure 1 is connected to a third conductive connection pad 30 of the second semiconductor structure 3 through the second conductive connection pad 240 of the semiconductor interconnection structure 2, the conductive pillar 210, and the first conductive connection pad 220. The first semiconductor structure 1 and the second semiconductor structure 3 include but are not limited to a circuit board, a package substrate, a logic chip, a storage chip, and the like.

The semiconductor package structure employs the semiconductor interconnection structure 2 as a connection intermediary layer between the two semiconductor structures. Heat dissipation performance and mechanical performance of the semiconductor package structure are greatly improved, and stability of the semiconductor package structure is improved.

The foregoing descriptions are merely example implementations of the present invention. It should be noted that a person of ordinary skill in the art may make several improvements or polishing without departing from the principle of the present invention and the improvements or polishing shall fall within the protection scope of the present invention.

## Claims

1. A semiconductor interconnection structure, comprising:
a base having a first surface and a second surface disposed opposite to each other;
a plurality of independent conductive pillars disposed in the base, each of the conductive pillars extending from the first surface to the second surface, a first end of the conductive pillar being exposed to the first surface, and a second end of the conductive pillar being exposed to the second surface; and
a first conductive connection pad disposed on the first surface of the base, the first conductive connection pad comprising a mesh structure, the mesh structure comprising a plurality of first nodes, each of the first nodes being connected to a first end of one or first ends of more of the conductive pillars, or a first end of each of the conductive pillars being connected to one or more of the first nodes, and first ends of all the conductive pillars being interconnected through the first conductive connection pad.

2. The semiconductor interconnection structure according to claim 1, wherein the first conductive connection pad comprises first patterns extending in a first direction and arranged at intervals in a second direction, and second patterns extending in the second direction and arranged in the first direction, and an intersection between the first pattern and the second pattern is the first node.

3. The semiconductor interconnection structure according to claim 1, wherein the first node covers the first end of the conductive pillar.

4. The semiconductor interconnection structure according to claim 1, further comprising a second conductive connection pad, the second conductive connection pad being disposed on the second surface of the base and connected to the second end of the conductive pillar, and second ends of all the conductive pillars being interconnected through the second conductive connection pad.

5. The semiconductor interconnection structure according to claim 4, wherein the second conductive connection pad comprises a mesh structure, the mesh structure comprises a plurality of second nodes, and each of the second nodes is connected to a second end of one or second ends of more of the conductive pillars, or a second end of each of the conductive pillars is connected to one or more of the second nodes.

6. The semiconductor interconnection structure according to claim 5, wherein the second conductive connection pad comprises third patterns extending in a first direction and arranged at intervals in a second direction, and fourth patterns extending in the second direction and arranged in the first direction, and an intersection between the third pattern and the fourth pattern is the second node.

7. The semiconductor interconnection structure according to claim 5, wherein the second node covers the second end of the conductive pillar.

8. The semiconductor interconnection structure according to claim 1, wherein the base has a thickness of 30-50 micrometers.

9. The semiconductor interconnection structure according to claim 8, wherein the conductive pillar has a size range of 2-5 micrometers on a cross section parallel to the base.

10. The semiconductor interconnection structure according to claim 1, wherein the conductive pillar is integrally formed with the first conductive connection pad.

11. The semiconductor interconnection structure according to any one of claims 1 to 10, wherein the first surface has a recess region, the recess region forms a trench, and the first conductive connection pad is at least partially located within the trench.

12. The semiconductor interconnection structure according to any one of claims 1 to 10, further comprising a seed layer, the seed layer being disposed between the conductive pillar and the base and between the first conductive connection pad and the base.

13. A method for forming a semiconductor interconnection structure, comprising:
providing a base;
forming a plurality of through-holes and a plurality of trenches in the base, the plurality of trenches being connected to form a mesh trench, one node opening of the mesh trench exposing one or more of the through-holes, or one or more node openings of the mesh trench exposing one of the through-holes;
filling the through-holes and the mesh trench with a conductive material to form conductive pillars in the through-holes and to form a first conductive connection pad in the mesh trench; and
thinning the base and exposing an end, away from the first conductive connection pad, of the conductive pillar.

14. The method for forming a semiconductor interconnection structure according to claim 13, wherein the step of forming the through-holes and the mesh trench in the base comprises:
forming through-holes in the base, the through-holes being arranged in an array in a first direction and a second direction; and
removing a partial thickness of the base to form a plurality of first trenches and a plurality of second trenches, the first trenches extending in the first direction and being arranged at intervals in the second direction, the second trenches extending in the second direction and being arranged at intervals in the first direction, the first trench and the second trench running through the through-hole, and an intersection region between the first trench and the second trench being the node opening.

15. The method for forming a semiconductor interconnection structure according to claim 13, wherein the step of forming the through-holes and the mesh trench in the base comprises:
removing a partial thickness of the base to form a plurality of first trenches and a plurality of second trenches, the first trenches extending in the first direction and being arranged at intervals in the second direction, the second trenches extending in the second direction and being arranged at intervals in the first direction, and an intersection region between the first trench and the second trench being the node opening; and
removing the base in a direction perpendicular to the base at the node opening to form the through-hole.

16. The method for forming a semiconductor interconnection structure according to claim 13, before the step of filling the through-holes and the mesh trench with a conductive material, further comprising: forming a seed layer on inner walls of the through-holes and the mesh trench; and
covering, by the conductive material, the seed layer, and fully filling the through-holes and the mesh trench in the step of filling the through-holes and the mesh trench with a conductive material.

17. A semiconductor package structure, comprising the semiconductor interconnection structure according to any one of claims 1-12.
